# EUROPEAN PATENT APPLICATION

(11) **EP 2 109 219 A2**
(43) Date of publication of application: **14.10.2009**
(21) Application number: 09157763.5
(22) Date of filing: 09.04.2009
(51) Int. Cl.: H03H 9/21, H03H 9/10

(54) **Piezoelectric vibrating devices and methods for manufacturing same**

(30) Priority: 10.04.2008 JP 2008102256
(71) Applicant: Nihon Dempa Kogyo Co., Ltd., Shibuya-ku Tokyo 151-8569 (JP)
(72) Inventor: Nishimura, Yuya, Saitama (JP); Sugiyama Toshio, Saitama (JP)
(74) Representative: Zimmermann & Partner

(57) **Abstract**

An exemplary piezoelectric device includes a base having a first connection electrode electrically connected to an external electrode. A second connection electrode is connected to the first connection electrode on a first main surface of a supporting member affixed to the base. A third connection electrode, formed on a second main surface of the supporting member, is electrically connected to the second connection electrode. A piezoelectric vibrating piece is affixed to the supporting member by application of an adhesive applied to the third connection electrode. The piezoelectric vibrating piece and includes excitation electrodes. A convexity is located and extends in a designated direction relative to the third connection electrode to prevent applied adhesive from spreading beyond a designated area of the piezoelectric vibrating piece.

## Description

### Cross-Reference to Related Application

This application claims priority to and the benefit of Japan Patent Application No. 2008-102256, filed on April 10, 2008, in the Japan Patent Office, the disclosure of which is incorporated herein by reference in its entirety.

### Field

This disclosure pertains, *inter alia,* to piezoelectric vibrating devices comprising supporting members made using piezoelectric substrates, and to methods for manufacturing same.

### Description of the Related Art

Various types of clocks, home electric appliances, and consumer electronics, and various types of commercial/industrial electrical apparatus such as information/communication devices and Office-Automation devices utilize at least one oscillator. These oscillators typically are manufactured by packaging a piezoelectric resonator, a piezoelectric vibrating piece, or an IC chip as a clock source for addition to and use by an electronic circuit of the apparatus. In other apparatus, piezoelectric timing devices such as real-time clock modules are widely used.

Especially nowadays, piezoelectric vibrating pieces and devices must be increasingly miniaturized and/or provided with a thinner or smaller profile to be accommodated in electronic devices and packaging schemes that are correspondingly miniaturized and/or provided with a thinner profile. Also, modem piezoelectric devices must be able to provide a low CI (crystal impedance) value, high quality, and stability.

During manufacture of a piezoelectric device, a piezoelectric vibrating piece is affixed to a base by an electrically conductive adhesive that bonds the piece to the base. This mounting of the piezoelectric vibrating piece on the base may generate stress in the piezoelectric vibrating piece, which can change the temperature characteristics of the piezoelectric vibrating piece. Stress can also increase or cause fluctuation in the CI value and increase the dependency characteristics of the drive level of the device.

A piezoelectric vibrating piece as disclosed in Japanese Unexamined Patent Application Publication No. 2007-19513 is affixed on a package base via a supporting member and electrically conductive adhesive. More specifically, Japanese Unexamined Patent Application Publication No. 2007-19513 utilizes the supporting member for holding the piezoelectric vibrating piece as the piece is being affixed to the base during packaging of the piezoelectric vibrating piece.

However, with increasing demand for more miniaturization, the area in which an electrically conductive adhesive can be applied, as well as the amount of such adhesive actually applied, must be optimized. Use of a supporting member with increasingly miniaturized devices may allow applied electrically conductive adhesive to spread out excessively, which can prevent the DLD (Drive Level Dependency) of the device from being reduced sufficiently and can cause an excessive increase or fluctuation in CI value.

In view of the foregoing, the current disclosure provides more miniaturizable piezoelectric vibrating devices having stable temperature characteristics, CI values, and vibration frequencies, and of methods for manufacturing same.

### Summary

Various aspects of the subject invention are described below. According to a first aspect, piezoelectric devices are provided. An embodiment of such a device comprises a base having a first connection electrode that is electrically connected to an external electrode. A supporting member is affixed to the base and comprises a second connection electrode and a third connection electrode. The second connection electrode connects the first connection electrode on a first main surface of the supporting member, and the third connection electrode is electrically connected to the second connection electrode formed on an opposite (second main) surface of the first surface. A piezoelectric vibrating piece is affixed to the supporting member by an adhesive applied to the third connection electrode. The piezoelectric vibrating piece includes an excitation electrode and an extraction electrode electrically connected to the excitation electrode. The third connection electrode is formed on a convexity of the supporting member in a designated direction. The convexity prevents the adhesive from excessively spreading on the piezoelectric vibrating piece beyond a designated area. According to this embodiment, whenever an excessive amount of adhesive is applied, the adhesive flows down the convexity rather than flowing laterally to across the piezoelectric vibrating piece (e.g., to another excitation electrode).

In another embodiment of a piezoelectric device the supporting member has a rectangular shape. Respective third connection electrodes are formed at each of the four corners of the supporting member. With such a configuration, the piezoelectric devices can be aligned with respect to either the right or left of the supporting member.

A piezoelectric device according to a third embodiment has a supporting member that is rectangular in shape. Multiple third connection electrodes are formed on at least a first main surface of supporting member. The piezoelectric devices of this embodiment do not require extra connection electrodes. Hence, manufacturing costs can be reduced.

In a piezoelectric device according to a fourth embodiment the adhesive is electrically conductive and the third connection electrode and the extraction electrode are electrically connected together via the electrically conductive adhesive.

In a piezoelectric device according to a fifth embodiment, the third connection electrode and the extraction electrode are electrically connected together via wire bonding.

In a piezoelectric device according to a sixth embodiment, the first connection electrode and the third connection electrode are at least 10% of the longitudinal length of the piezoelectric device away from each other in the longitudinal direction of the supporting member. With such a configuration, the effects of stress imparted by hardening of the adhesive can be reduced. Reducing stress reduces unwanted changes of vibration frequency after adhesive bonding, allowing piezoelectric devices to be manufactured having stable vibration frequencies.

Piezoelectric vibrating devices according to various embodiments exhibit less reduction of their CI values as they are miniaturized. This allows the piezoelectric devices to meet performance demands of miniaturization.

### Brief Description of the Drawings

FIG. 1A is a piezoelectric vibrating device 50 according to a first embodiment.
FIG. 1B is a cross-sectional view taken along the B-B line of FIG. 1A.
FIG. 2A is a piezoelectric vibrating device 55 according to a second embodiment.
FIG. 2B is a cross-sectional view taken along the A-A line of FIG. 2A.
FIG. 3 is a graph showing the magnitude of change of vibration frequency caused by differences in the distance JL before and after reflow.
FIG. 4A includes a plan and side view of an embodiment in which the supporting member 6a includes respective convexities (projections) 65 at the four corners of the supporting member.
FIG. 4B includes a plan and side view of an embodiment in which the supporting member 106 does not include any convexities.
FIG. 5 is a graph of CI versus temperature exhibited by an AT-cut crystal vibrating piece 40 affixed to a supporting member 6a having convexities 65 and an AT-cut crystal vibrating piece 40 affixed to a supporting member 106 lacking convexities.
FIG. 6A is a bar graph of DLD characteristics of the piezoelectric vibrating device 50 affixed to a supporting member 6a including convexities 65.
FIG. 6B is a bar graph of DLD characteristics of the piezoelectric vibrating device 50 affixed to a supporting member 106 lacking convexities.
FIG. 7A includes a plan and side view of the supporting member 6b of a first alternative example configuration.
FIG. 7B includes a plan and side view of the supporting member 6c of a second alternative example configuration.
FIG. 8 includes a plan and side view of the supporting member 6d of a third alternative example configuration.
FIG. 9A includes a plan and side view of the supporting member 6e of a fourth alternative example configuration.
FIG. 9B includes a plan and side view of the supporting member 6f of a fifth alternative example configuration.
FIG. 10A includes a plan and side view of the supporting member 6g of a sixth alternative example configuration.
FIG. 10B includes a plan and side view of the supporting member 6h of a seventh alternative example configuration.

### Detailed Description

### First Embodiment

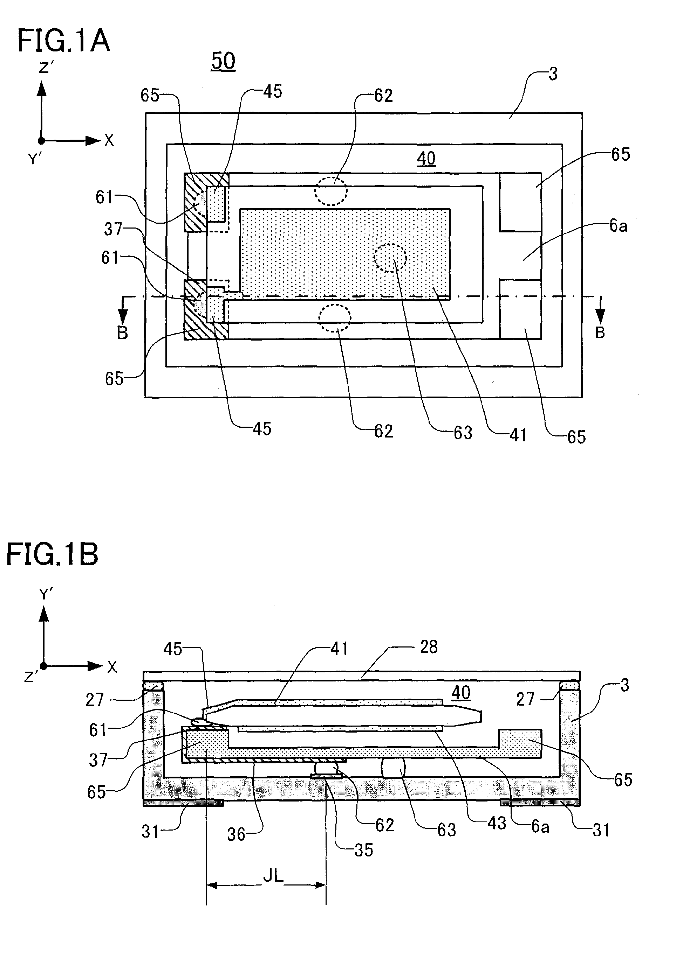

FIG. 1A depicts a piezoelectric vibrating device 50 of the first embodiment. FIG. 1B is a cross-sectional view taken along the line B-B in FIG. 1A. As shown in FIGS. 1A and 1B, the piezoelectric vibrating device 50 comprises an AT-cut crystal vibrating piece 40, a base 3 holding the piece 40, a lid 20 for air-tight sealing, and a supporting member 6a. In the piezoelectric device 50 the AT-cut crystal vibrating piece 40 is situated in a space formed by the base 3 and lid 28.

With respect to quartz crystal, the "AT-cut" is one in which the main surface (YZ surface) is tilted 35° 15' in the Y-axis direction from the Z-axis to the Y-axis of the crystal axes (XYZ). Hereinbelow, whenever the axial direction of an AT-cut crystal vibrating piece is described, the generally-tilted new axes are denoted the Y' axis and the Z' axis.

As FIGS. 1A and 1B show, on the both edges in X direction of the AT-cut crystal vibrating piece 40, the edges are processed, such as by beveling or convex trimming. A first excitation electrode 41 is formed on the first main (upper) surface, and a second excitation electrode 43 is formed on the second main (lower) surface. The first excitation electrode is connected to one extraction electrode 45, and the second excitation electrode 43 is connected to another extraction electrode 45 formed on the second main surface. The excitation electrodes are used to apply a voltage to the AT-cut crystal vibrating piece 40, which causes the crystal vibrating piece to oscillate at a designated frequency.

The AT-cut crystal vibrating piece 40 shown in FIGS. 1A and 1B is an edge-processed vibrating piece attached to a supporting member using electrically conductive adhesive. Alternatively, the crystal vibrating piece can be a non-edge-processed AT-cut crystal vibrating piece mounted to the supporting member 6a by electrically conductive adhesive. Further alternatively, a reverse-mesa type AT-cut crystal vibrating piece can be mounted on the supporting member 6a.

The base 3 is made of ceramic, for example, by layering a plurality of ceramic sheets to form a box shape and then firing the ceramics. On the inside bottom surface of the base 3 a first connection electrode 35 is formed. On the outside bottom surface of the base 3 an external electrode 31 is formed. The first connection electrode 35 and the external electrode 31 are connected together electrically. Using such a base 3, the piezoelectric vibrating device 50 can be an SMD (Surface Mount Device). The dimension of the base 3 in the X-direction is about 5.0 mm and in the Z'-direction is about 3.0 mm.

The supporting member 6a in this embodiment is made of a rectangle-shaped crystal material. As shown in FIG. 1A, respective upward projections (generally termed "convexities") 65 are formed on the four corners of the supporting member. By way of example, the dimension of the supporting member 6a in the X-direction is about 3.4 mm and in the Z'-direction is about 1.8 mm. Also by way of example, the thickness (Y'-direction) of the supporting member 6a is about 0.16 mm, and the height of the convexities 65 is about 0.06 mm. The supporting member 6a includes respective third connection electrodes 37 on the upper surfaces of two convexities 65. A second connection electrode 36 is provided on the under-surface (second main surface) of the supporting member 6a. The second and third connection electrodes 36, 37 comprise metal layers (e.g., gold layer on a chrome layer). Thus, the second and third connection electrodes 36, 37 are electrically conductive.

As shown in FIG. 1B, the supporting member 6a is affixed by two applications of electrically conductive adhesive. One adhesive application 62 is on the first connection electrode 35 of the base 3. The other adhesive application 63 is at substantially the center of the supporting member 6a, affixing the supporting member to the base 3. The AT-cut crystal vibrating piece 40 is affixed to the supporting member 6a by the electrically conductive adhesive 61.

Application of the electrically conductive adhesive 62, 63, for example, to mount the supporting member 6a to the base 3 is followed by a curing operation that hardens (cures) the units 62, 63 of applied adhesive. Thus, the supporting member 6a is supported relative to the base 3 by the units 62, 63 of cured adhesive. The base 3, AT-cut crystal vibrating piece 40, and supporting member 6a are bonded electrically and mechanically together by the units of electrically conductive adhesive 61, 62, and then further bonded to the base by the unit of adhesive 63.

Hence, the third connection electrode 37 and external electrode 31 are connected together through the supporting member 6a, and the extraction electrode 45 of the AT-cut crystal vibrating piece 40 is electrically connected to the external electrode 31 of the base 3.

As an alternative to the embodiment shown in FIGS. 1A-1B, other bonding methods can be used besides use of electrically conductive adhesive 61. For example, non-electrically conductive adhesive can be used. In another example, the third connection electrode 37 and the extraction electrode 45 of the AT-cut crystal vibrating piece 40 are connected together by wire bonding. The AT-cut crystal vibrating piece 40 can be electrically connected to the external electrode 31 of the base 3.

FIG. 1B shows a dimension JL in the X-direction between the locations of the units 61, 62 of electrically conductive adhesive. The dimension JL desirably is greater than 0.5 mm, and the bonding positions (of the units 61, 62) desirably are greater than 10 % of the full length of the base 3.

### Second Embodiment

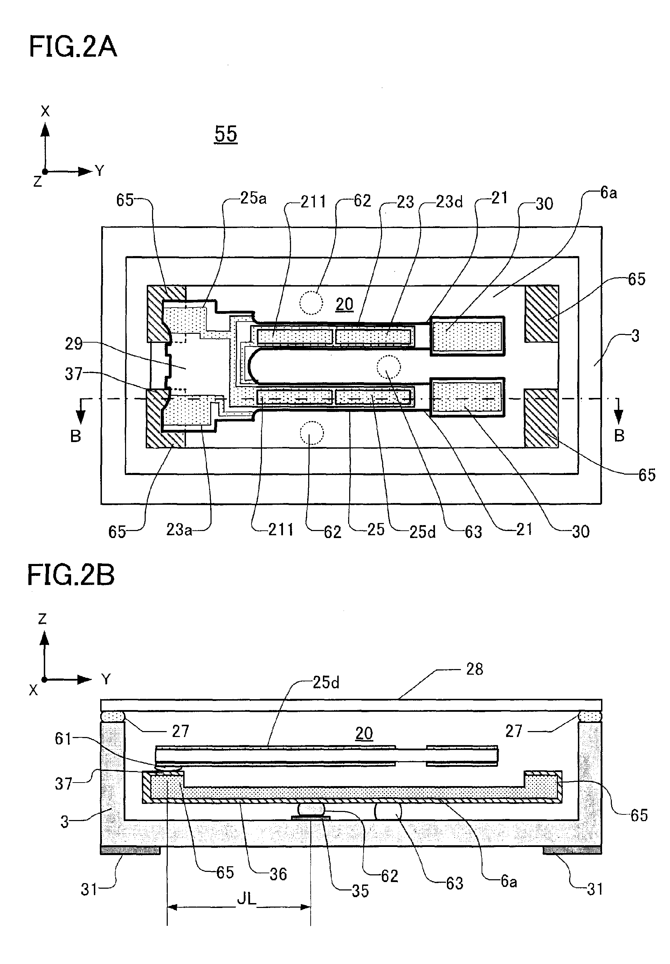

A piezoelectric vibrating device 55 of this embodiment is shown in FIGS. 2A and 2B. FIG. 2A shows the device 55 with the lid 28 removed. FIG.2B is a cross-sectional view taken along the line B-B line in FIG. 2A. In the second embodiment, components having the same respective reference numerals as corresponding components in the first embodiment have the same respective functions and configurations.

The piezoelectric vibrating device 55 comprises a tuning-fork type crystal vibrating piece 20, a base 3 holding the piece 20, a lid 28 for air-tight sealing, and a supporting member 6a. The tuning-fork type crystal vibrating piece 20 is situated in a space defined by the base 3 and lid 28. The tuning-fork type crystal vibrating piece 20 oscillates at a frequency of, for example, 32.768 kHz. Not intending to be limiting, the piece 20 has the following exemplary dimensions: Y-direction length about 1.45 mm, X-direction about 0.5 mm, and Z-direction height about 0.1 mm.

The tuning-fork type crystal vibrating piece 20 comprises, as FIG. 2A shows, a pair of vibrating arms 21 extending substantially parallel from a base 29. Grooves 211 are formed on both the upper and lower surfaces of the vibrating arms 21. Each groove 211 has a depth of 30% to 40% the thickness of the arms. Hence, in the region of grooves, each arm has a cross-sectional profile (in the XZ plane) in a groove region that is substantially H-shaped. The grooves 211 serve to reduce the CI value of the tuning-fork type crystal vibrating piece 20. Note that, in this embodiment, two grooves are formed on each of the upper and lower surfaces of each vibrating arm. In general, the number of grooves on each surface is one or more, which is effective for reducing the CI value.

The base 29 of the tuning-fork type crystal vibrating piece 20 has a flat, board shape. The width of the base 29 (as viewed from above) has two stages. During oscillation of the vibrating arms, if an oscillation containing a vertical directional component occurs, the shape of the base 29 can be adjusted to reduce oscillation of the vibrating arms 21 that otherwise would leak to the supporting member 6a from the base 29.

A first excitation electrode 23d and second excitation electrode 25d are formed on the first and second main surfaces, respectively, of the tuning-fork type piezoelectric vibrating piece 20. The first excitation electrode 23d is connected to a first extraction electrode 23a formed on the base 29, and the second excitation electrode 25d is connected to a second extraction electrode 25a formed on the base 29. Whenever a voltage is applied to the first and second extraction electrodes 23a, 25a, the tuning-fork type crystal vibrating piece 20 oscillates at a designated frequency. The tip of each vibrating arm 21 includes respective weights 30 formed on each of the upper and lower surfaces of the arms. The weights 30 cause the vibrating arms 21 to oscillate easily and allow control and setting of the vibration frequency.

The first and second extraction electrodes 23a, 25a, the first and second excitation electrodes 23d, 25d, and the weights 30 of the tuning-fork type piezoelectric vibrating piece 20 comprise respective metal layers. Example metal layers are 400-2000 Ångstroms of gold (Au) layered on 150-700 Ångstroms of chrome (Cr).

The base 3 is made of, for example, ceramic. Example outside dimensions of the base 3 are 5.0 mm in the Y-direction and about 3.2 mm in the X-direction. The supporting member 6a desirably is made of a rectangle-shaped unit of crystal. As shown in FIG. 2A, a respective convexity (upward projection) 65 is situated on each corner of the supporting member 6a. Example dimensions of the supporting member 6a are about 3.4 mm in the Y-direction and about 1.8 mm in the X-direction. The supporting member 6a shown in FIGS. 2A and 2B includes a third connection electrode 37 situated on the upper main surface of each of a pair of convexities 65. The second electrode 36 on the lower surface of the supporting member 6a extends in the Y-direction.

The first extraction electrode 23a and the second extraction electrode 25a are electrically connected to the external electrode 31. Alternatively, the tuning-fork type crystal vibrating piece 20 can be electrically connected to the external electrode 31 of the base 3 using a third connection electrode 37. This connection can be made by wire bonding using a non-electrically conductive adhesive instead of electrically conductive adhesive 61.

As in the first embodiment, the dimension JL, representing the distance between the first connection electrode 35 on the electrically conductive adhesive 61 and the third connection electrode 37 on the electrically conductive adhesive 62, desirably is no greater than 10 % of the length of the base 3.

### Changing Vibration Frequency by Curing Adhesive

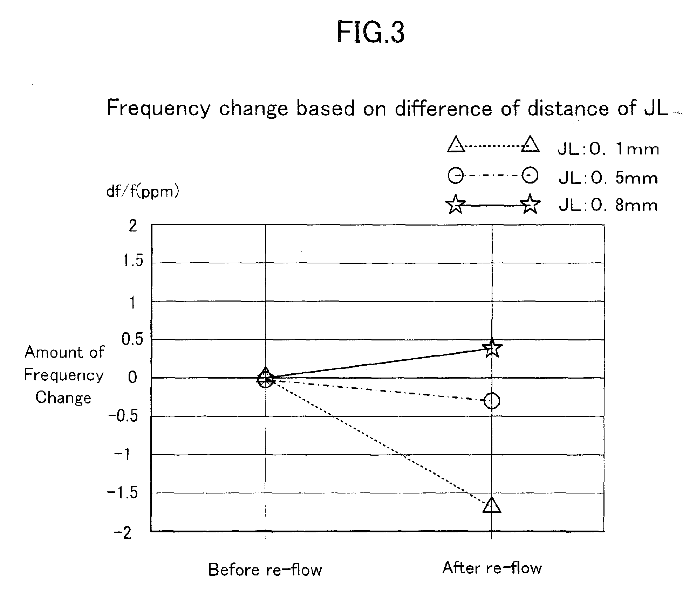

FIG. 3 is a graph of frequency variation exhibited by the first piezoelectric vibrating device 50 shown in FIG. 1 before and after the adhesive has been cured (hardened) in a reflow furnace. The vertical axis is change of frequency df/f (ppm). In the data of FIG.3 the amount of frequency variation (Hz) is divided by the frequency (Hz) of a reference crystal oscillator to produce data in units of ppm.

The data in FIG. 3 compare a case in which the distance JL (between bonding points of the first connection electrode 35 and the third connection electrode 37) is 0.0 mm, 0.5 and 0.8 mm. Each sample is reflowed twice for 10 seconds in 260 °C, and the amount of frequency variation is compared before and after reflow. Whenever the distance JL is 0.0 mm, the frequency charge is about -1.7 ppm, whenever the distance JL is about -0.3 ppm, and whenever the distance JL is about 0.8 mm, the frequency variation is +0.4 ppm. Thus, the amount of frequency variation depends on the distance JL.

If the distance JL between the first connection electrode 35 and the third connection electrode 37 is too small, then stress arising during hardening of the electrically conductive adhesive 61, 62 and of the adhesive 63 for the base may adversely affect the tuning-fork type crystal vibrating piece 20 when it is mounted to the base 3. A sufficient distance JL between the first connection electrode 35 and the third connection electrode 37 can ease the stress. The distance JL is preferably equal to or greater than 0.5 mm, so as to produce only small frequency variations at most.

### Supporting member 6a

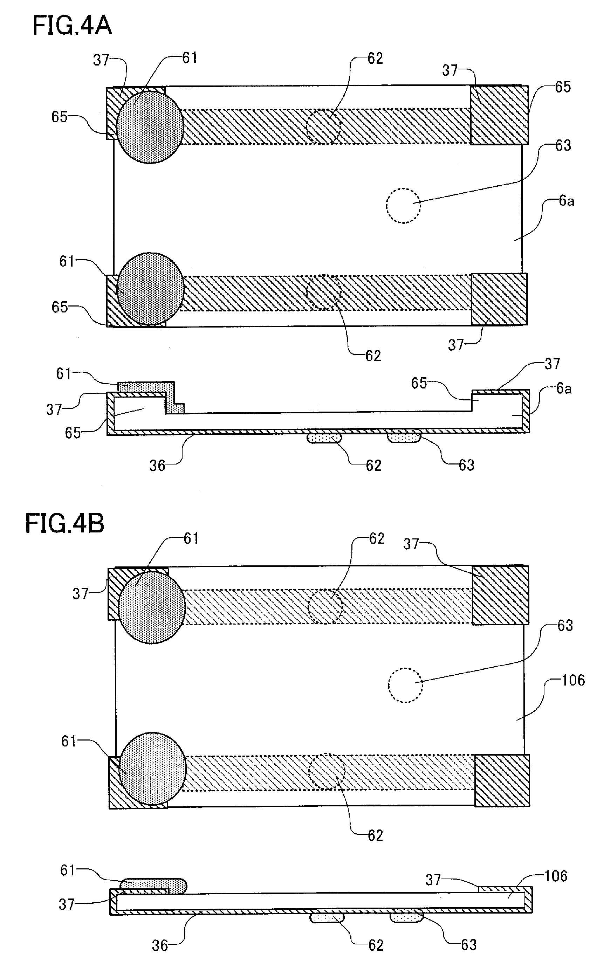

FIG. 4A includes plan and side views of a supporting member 6a having convexities 65. FIG. 4B includes plan and side views of a supporting member 106 without convexities. Each of the first and second embodiments comprises a supporting member 6a having a respective convexity 65 at each of the four corners of the supporting member. In FIG. 4A the convexity is formed by dicing or cutting the rectangularly shaped crystal material. The supporting member 6a includes respective third connection electrodes 37 on the surface of each convexity 65. The third connection electrode 37 is electrically connected to the second connection electrode 36 on the under-surface of the supporting member 6a.

The tuning-fork type crystal vibrating piece 20 (second embodiment) or the AT-cut crystal vibrating piece 40 (first embodiment) has only a pair of excitation electrodes, so only a pair of third connection electrodes need be formed in either case. However, by forming the convexities 65 on the four corners of the supporting member and thus by configuring the supporting member 6a in a symmetric manner, the process by which the supporting member 6a is mounted on the base 3 can be simplified.

The electrically conductive adhesive 61 is applied on a selected pair of third connection electrodes 37 using a dispenser (not shown). The extent to which the electrically conductive adhesive 61 is allowed to spread laterally on the third connection electrode is controllable, and can be varied as required. FIGS. 4A and 4B show the electrically conductive adhesive 61 after application and controlled spreading.

In FIG. 4B, the AT-cut crystal vibrating piece 40 (not shown but see FIG. 1) or tuning-fork type crystal vibrating piece 20 (not shown but see FIG. 2) is mounted on the supporting member 106 lacking the convexities. If an excess amount of the electrically conductive adhesive 61 is applied, it may undesirably spread to the excitation electrodes on the AT-cut crystal vibrating piece 40 or tuning-fork type crystal vibrating piece 20.

In FIG. 4A, in contrast, the third connection electrodes 37 are formed on top of two of the convexities 65 of the supporting member 6a. If excess electrically conductive adhesive 61 is applied to the convexities, some of the adhesive may run down the sides of the convexities, but the convexities in this manner prevent the adhesive from spreading to the sides of the AT-cut crystal vibrating piece 40 or tuning-fork type crystal vibrating piece 20. Therefore, by using the supporting member 6a having convexities 65, the first piezoelectric vibrating device 50 and the second piezoelectric vibrating device 55 so formed have stable thermal characteristics, CI value, and frequency.

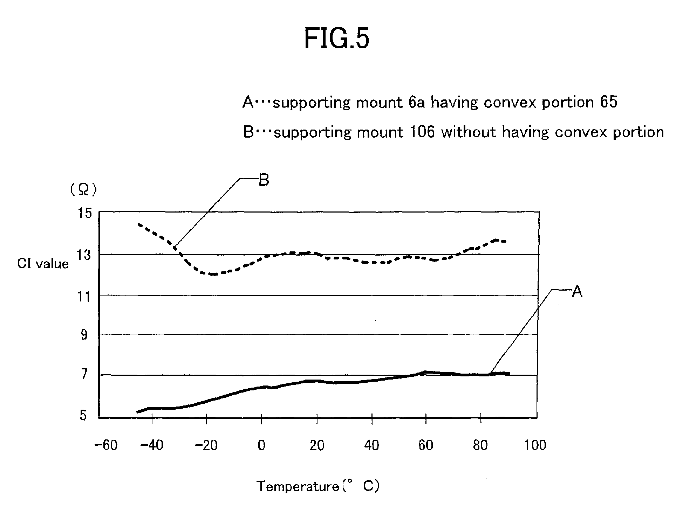

FIG. 5 is a graph comparing the thermal characteristics of an AT-cut crystal vibrating piece 40 mounted to a supporting member 6a having convexities 65 and of an AT-cut crystal vibrating piece 40 mounted to a supporting member 106 lacking convexities. The ordinate is CI value, in units of ohms (Ω), and the abscissa is temperature (°C). Line A is of thermal characteristics exhibited in the case of using a supporting member 6a having convexities 65. The dashed line B is of thermal characteristics realized in the case of using a supporting member 106 lacking convexities. The AT-cut crystal vibrating piece 40 mounted to the supporting member 106 without convexities exhibits an initially large CI value that changes or fluctuates with increases in temperature. These data reflect a failure, when convexities are absent, to limit the extent of lateral spread of the electrically conductive adhesive 61, used for affixing the AT-cut crystal vibrating piece to the supporting member 106 lacking convexities, when the adhesive is applied to the third connection electrodes 37. In contrast, the AT-cut crystal vibrating piece 40 mounted to the supporting member 6a including convexities 65 exhibits a lower CI value and less thermally caused fluctuation in CI. If excess electrically conductive adhesive runs down the sides of the convexities 65 rather than spreading out laterally, the adhesive has less adverse effect on AT-cut crystal vibrating piece 40.

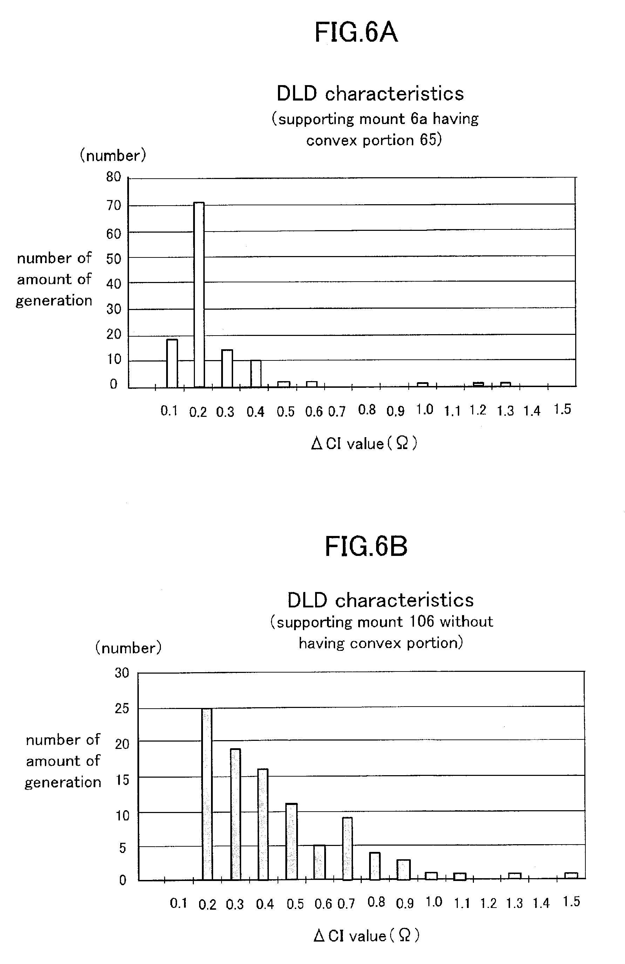

FIGS. 6A and 6B are bar graphs comparing DLD (Drive Level Dependency) characteristics of the piezoelectric vibrating device 50 comprising the supporting member 6a including convexities 65 (FIG. 6A) and the piezoelectric vibrating device 50 comprising the supporting member 106 lacking the convexities, respectively. To obtain the data, 50 µA of current was initially applied to the piezoelectric vibrating device 50; then, the current was increased to a maximum of 5 mA and reduced back to 50 µA. The abscissa in each graph is the difference in CI value (ΔCI) obtained during the initial application of 50 µA and during the second application of this current. The ordinate in each graph is the number of devices that generated the noted ΔCI value. During manufacture of the piezoelectric vibrating devices 50 used for testing, application of the electrically conductive adhesive 61 was not controlled to achieve application of an extra amount but rather controlled to achieve application of the precise amount needed and no more.

More specifically, 50 µA of current was applied to 120 piezoelectric vibrating devices 50 individually. The current was increased to 5 mA and then returned to 50 µA. In FIG. 6A, seventy-one devices exhibited a ΔCI value of 0.2 Ω; the remaining devices exhibited a value equal to or less than 0.4 Ω. In contrast, in FIG. 6B, the same current was applied to 120 piezoelectric vibrating devices in which the supporting member 106 lacked convexities. The obtained ΔCI values ranged from 0.2 Ω to 0.9 Ω. Also, the average was poor, reflecting large fluctuations.

As understood from FIGS. 5A-5B and 6A-6B, the piezoelectric vibrating devices 50 comprising supporting members 6a having convexities 65 have more stable temperature characteristics and CI values than the piezoelectric devices lacking convexities.

### Alternative Examples of the Supporting member

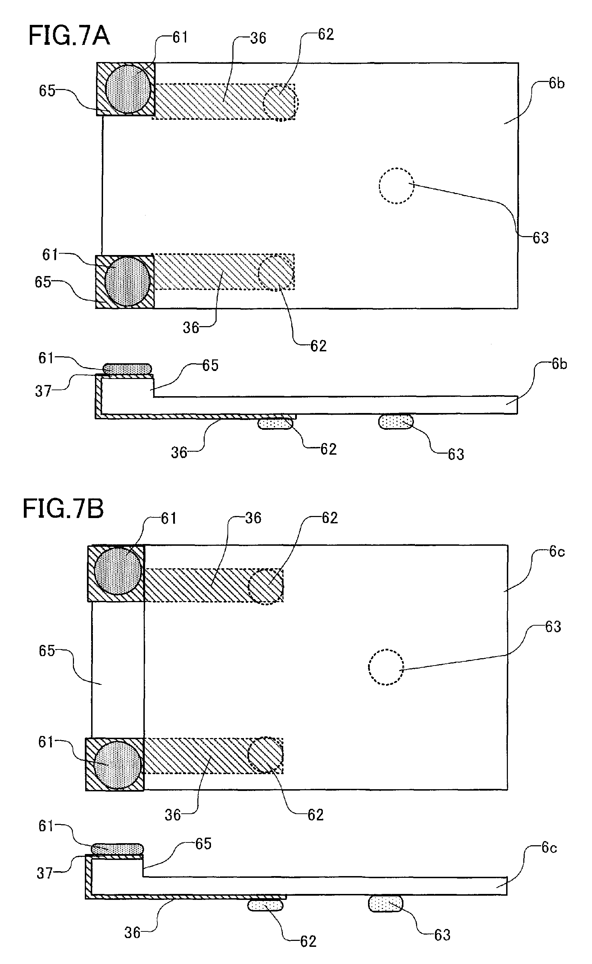

FIGS. 7A-7B, 8, 9A-9B, and 10A-10B depict alternative examples in which the configuration of the supporting member 6a (FIGS. 4A-4B) can be changed and still have a functioning piezoelectric vibrating device after application and curing of adhesive. In all these examples, the supporting member 6 is formed such that the electrically conductive adhesive 61 does not spread laterally to the edges of the tuning-fork type crystal vibrating piece 20 or the AT-cut crystal vibrating piece 40. The same reference numbers are used for components that are similar to respective components shown in FIGS. 4A-4B.

FIG. 7A includes plan and side views of the supporting member 6b used in a first alternative example 1. The supporting member 6b includes a pair of convexities 65 provided on respective corners adjacent one edge of the supporting member 6b. The supporting member 6b includes respective third connection electrodes 37 on the upper surface of each convexity, and a respective second connection electrode 36 on the under-surface of the supporting member 6b. The tuning-fork type crystal vibrating piece 20 or the AT-cut crystal vibrating piece 40 has only a pair of excitation electrodes; thus, the convexities 65 are formed on two respective corners along one edge of the supporting member. Because unnecessary third connection electrodes 37 are not formed, the cost of manufacturing the supporting member 6b in this example can be reduced.

FIG. 7B includes plan and side views of the supporting member 6c used in a second alternative example. A uniform-width convexity 65 extends along one edge of the supporting member 6c and includes two corner regions of the supporting member 6c (the two left-hand corners in the figure). The supporting member 6c includes respective third connection electrodes 37 on the corner regions of the convexity and respective second connection electrodes 36 on the under-surface of the supporting member 6c. Since the supporting member 6c has only a single convexity 65, dicing and cutting processes for forming the mount and convexity are easier and less expensive to perform.

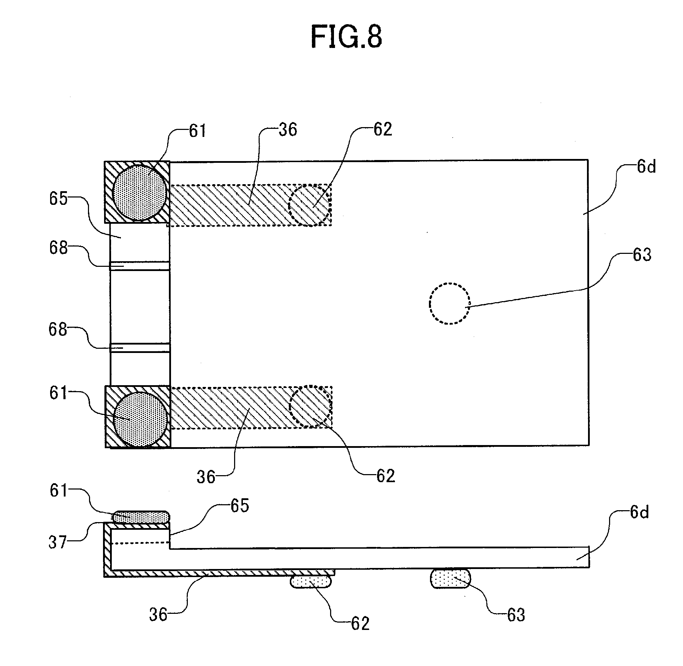

FIG. 8 includes plan and side views of the supporting member 6d used in a third alternative example. Referring back to the supporting member 6c of the second alternative example, it is possible that an excessive applied amount of electrically conductive adhesive 61 could flow between the pair of third connection electrodes 37 and cause an electrical short-circuit between them. In the third alternative example (FIG. 8), such a short-circuit is avoided by forming multiple slits 68 on the convexity 65. In this example, the slits 68 do not penetrate fully to the under-surface of the supporting member 6d, but they can. With the slits 68, even if an excessive amount of electrically conductive adhesive 61 is applied, the adhesive is prevented from spreading laterally across the space between the pair of connection electrodes 37.

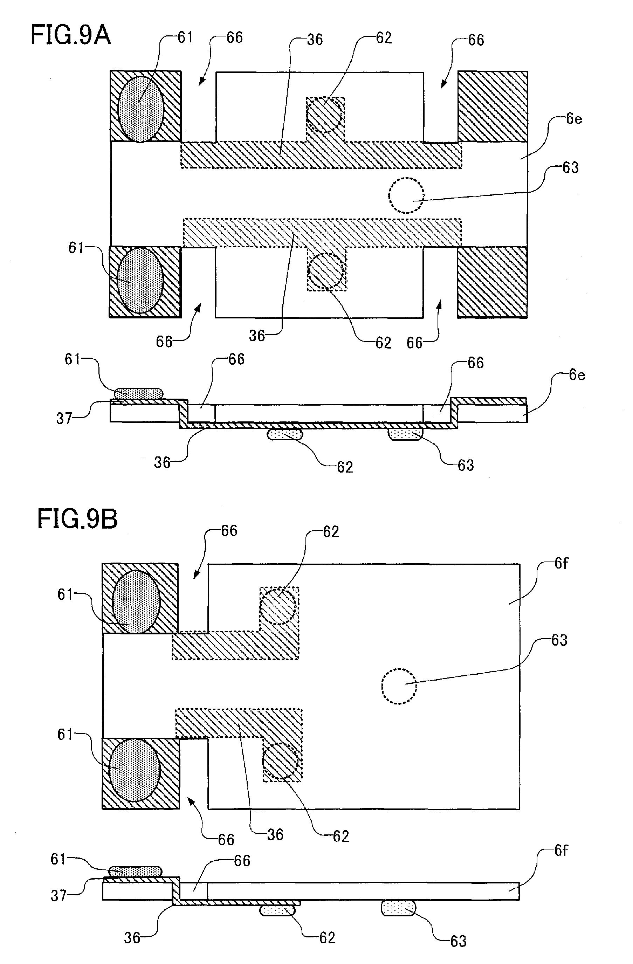

FIG. 9A includes plan and side views of the supporting member 6e in a fourth alternative example. Each of the four corners of the supporting member 6e includes a respective third connection electrode 37. Also, along each longitudinal (length-wise) edge of the supporting member 6e is a pair of cutaway voids 66. If an excessive amount of electrically conductive adhesive 61 is applied to a pair of third connection electrodes 37, the excess adhesive 61 runs to the voids 66 and stops, and thus does not spread to the excitation electrode of the AT-cut crystal vibrating piece 40 or of the tuning-fork type crystal vibrating piece 20. This configuration is effective to reduce the thickness (in the Z-direction of FIGS. 1 and 2) of the piezoelectric vibrating device 50 or the second piezoelectric device 55. Also, the symmetric configuration of the supporting member 6e makes alignment easier. Note that the second connection electrode 36 is formed around the void 66.

FIG. 9B includes plan and side views of the supporting member 6f in a fifth alternative example. In this example, the two left-hand corners of the supporting member 6f include respective third connection electrodes 37. Also, a respective cutaway void 66 is situated along each longitudinal edge of the supporting member 6f. If an excessive amount of electrically conductive adhesive 61 is applied to the third connection electrodes 37, the adhesive 61 runs to the voids 66 and stops, and does not spread to the excitation electrode of the AT-cut crystal vibrating piece 40 or the tuning-fork type crystal vibrating piece 20. This alternative example has fewer voids 66 than the fourth alternative example. In this example, the quantity of third connection electrodes 37 is reduced, and manufacturing costs are correspondingly reduced.

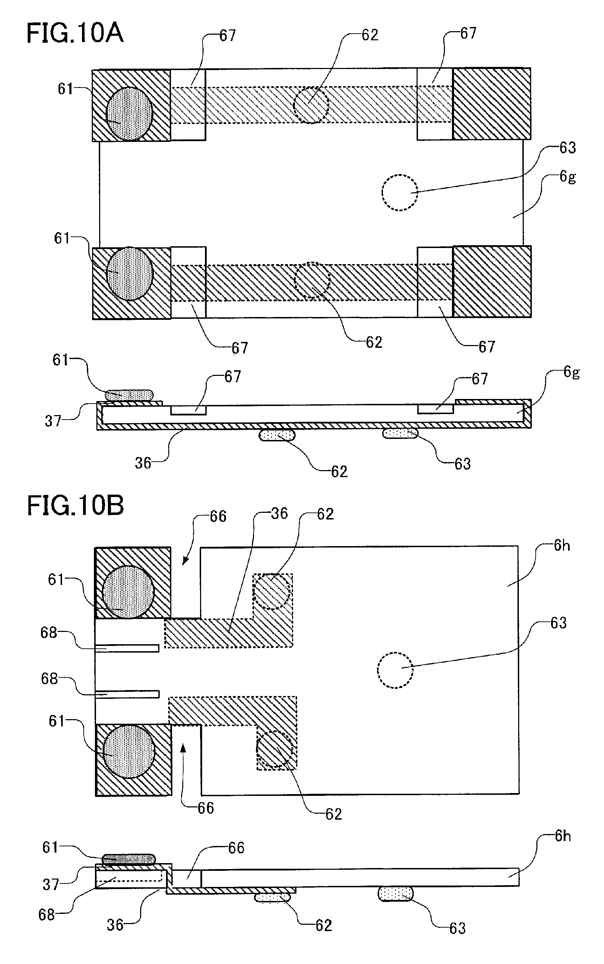

FIG. 10A includes plan and side views of the supporting member 6g in a sixth alternative example. In this example, each of the four corners of the supporting member 6f includes respective third connection electrodes 37. Also, two respective cutaway voids 66 are formed in each longitudinal edge of the supporting member 6g. If an excessive amount of electrically conductive adhesive 61 is applied to a pair of third connection electrodes 37, the adhesive 61 runs to the voids 66 and stops, rather than to the excitation electrode of the AT-cut crystal vibrating piece 40 or the tuning-fork type crystal vibrating piece 20. Even if the supporting member 6g is thinner than in other examples, its strength can be increased compared to the voids 66.

FIG. 10B includes plan and side views of the supporting member 6h in a seventh alternative example. In this example, the two left-hand corners of the supporting member 66h include respective third connection electrodes 37. Also, a respective cutaway void 66 is situated on each longitudinal edge. To avoid an electrical short between the third connection electrodes 37, multiple slits 68 are formed on the supporting member 6h. In the figure, these slits 68 do not penetrate to the under-surface of supporting member 6h, but they can. The slits 68 prevent electrically conductive adhesive 61 from flowing between and short-circuiting the excitation electrodes of the AT-cut crystal vibrating piece 40 or the tuning-fork type crystal vibrating piece 20.

While preferred embodiments and examples of the current invention have been described above, it will be understood by those skilled in the art that additional modifications and changes can be made to the embodiments and examples without departing from the spirit of the invention. For example, the embodiments are described as including an AT-cut crystal vibrating piece, but the cutting direction of the crystal can be in different direction than AT, such as BT cut, SC cut, and IT cut. Also, instead of using electrically conductive adhesive 61, a piezoelectric vibrating piece can be bonded by non-electrically conductive adhesive, and the third connection electrode 37 and the tuning-fork type crystal vibrating piece 20 can be connected together by wire bonding. The piezoelectric vibrating piece of the present invention can be made of lithium niobate or other piezoelectric single-crystal material besides quartz crystal.

## Claims

1. A piezoelectric vibrating device, comprising:
a base;
a first connection electrode situated on the base and being electrically connected to an external electrode;
a supporting member affixed to the base, the supporting member having a first main surface and a second main surface;
a second connection electrode situated on the first main surface and being electrically connected to the first connection electrode;
a third connection electrode situated on the second main surface and being electrically connected to the second connection electrode;
a piezoelectric vibrating piece affixed to the third connection electrode and hence to the supporting member by a unit of adhesive applied to the third connection electrode, the piezoelectric vibrating piece including an excitation electrode and an extraction electrode electrically connected to the excitation electrode, the third connection electrode being situated on an upper surface of convexity extending from the second main surface and configured to prevent lateral spread of the adhesive beyond a designated area of the piezoelectric vibrating piece.

2. The device of claim 1, wherein:
the adhesive is an electrically conductive adhesive; and
the third connection electrode and the extraction electrode are electrically connected to each other via the electrically conductive adhesive.

3. The device of claim 1, wherein each third connection electrode and respective extraction electrode are electrically connected together by wire bonding.

4. The device of claim 1 2, or 3, wherein:
the supporting member has a rectangular shape and includes four corner regions; and
a respective third connection electrode is situated at each of the corner regions of the supporting member.

5. The device of claim3 or 4, wherein:
the adhesive is an electrically conductive adhesive; and
the third connection electrode and the extraction electrode are electrically connected to each other via the electrically conductive adhesive.

6. The device of claim 3 or 4, wherein each third connection electrode and respective extraction electrode are electrically connected together by wire bonding.

7. The device of claim 4, wherein each of the first connection electrode and respective third connection electrode are separated from each other in a longitudinal direction of the supporting member, by a distance that is at least 10% of a longitudinal dimension of the piezoelectric vibrating device.

8. The piezoelectric device of claim 1, wherein:
the supporting member has a rectangular shape having four sides and four corners, each side including a respective pair of comers; and
respective third connection electrodes are situated at the respective corners of at least on one side of the supporting member.

9. The device of claim5 , wherein each of the first connection electrode and respective third connection electrode are separated from each other in a longitudinal direction of the supporting member, by a distance that is at least 10% of a longitudinal dimension of the piezoelectric vibrating device.

10. A piezoelectric vibrating device, comprising:
a base;
a first connection electrode situated on the base and being electrically connected to an external electrode;
a supporting member affixed to the base, the supporting member having a first main surface and a second main surface;
a second connection electrode situated on the first main surface and being electrically connected to the first connection electrode;
a third connection electrode situated on the second main surface and being electrically connected to the second connection electrode;
a piezoelectric vibrating piece affixed to the third connection electrode and hence to the supporting member by a unit of adhesive applied to the third connection electrode, the piezoelectric vibrating piece including an excitation electrode and an extraction electrode electrically connected to the excitation electrode, the supporting member defining at least one edge void situated to prevent lateral spread of the adhesive beyond a designated area of the piezoelectric vibrating piece.

11. A piezoelectric vibrating device, comprising:
a base;
a first connection electrode situated on the base and being electrically connected to an external electrode;
a supporting member affixed to the base, the supporting member having a first main surface and a second main surface;
a second connection electrode situated on the first main surface and being electrically connected to the first connection electrode;
a third connection electrode situated on the second main surface and being electrically connected to the second connection electrode;
a piezoelectric vibrating piece affixed to the third connection electrode and hence to the supporting member by a unit of adhesive applied to the third connection electrode, the piezoelectric vibrating piece including an excitation electrode and an extraction electrode electrically connected to the excitation electrode, the supporting member defining at least one slit situated to prevent lateral spread of the adhesive beyond a designated area of the piezoelectric vibrating piece.

12. The device of claim 11, wherein:
the supporting member has a rectangular shape having four sides and four corners, each side including a respective pair of comers;
the supporting member defines at least one convexity extending along a side and including the respective pair of corners associated with the side; and
the slit extends into the convexity.

13. A method for manufacturing a piezoelectric vibrating device, comprising:
forming a first connection electrode on a base;
connecting the first connection electrode to an external electrode on the base;
forming a supporting member having a first main surface, a second main surface, and a spread-inhibiting feature;
forming a second connection electrode on the first main surface and a third connection electrode on the second main surface;
affixing the supporting member to the base such that the second connection electrode on the second main surface is electrically connected to the first connection electrode;
forming a piezoelectric vibrating piece including an excitation electrode and an extraction electrode electrically connected to the excitation electrode;
applying a unit of adhesive to either or both the piezoelectric vibrating piece and supporting member and placing the piezoelectric vibrating piece to the supporting member such that the third connection electrode is electrically connected to at least one electrode on the piezoelectric vibrating piece;
allowing the unit of adhesive to spread while using the spread-inhibiting feature to prevent spread of adhesive beyond a pre-designated region of the supporting member and hence beyond a pre-designated region of the piezoelectric vibrating piece; and
curing the adhesive.

14. The method of claim 13, wherein the spread-inhibiting feature includes at least one convexity extending from the first main surface, on which convexity a least a portion of the third connection electrode is formed.

15. The method of claim 13, wherein the spread-inhibiting feature includes at least one slit in the supporting member.
